# EUROPEAN PATENT SPECIFICATION

(11) **EP 4 057 337 B1**
(45) Date of publication and mention of the grant of the patent: **28.08.2024**
(21) Application number: 22152268.3
(22) Date of filing: 19.01.2022
(51) Int. Cl.: H01L 23/36, H01L 23/24, H01L 23/42

(54) **ELECTRONIC DEVICE ADOPTING HEAT DISSIPATION STRUCTURE**
ELEKTRONISCHE VORRICHTUNG MIT WÄRMEABLEITUNGSSTRUKTUR
DISPOSITIF ÉLECTRONIQUE ADOPTANT UNE STRUCTURE DE DISSIPATION DE CHALEUR

(30) Priority: 09.03.2021 TW 110202467 U
(43) Date of publication of application: 14.09.2022
(60) Divisional application: 23154949.4
(73) Proprietor: Winchain Material Technology Co., Ltd., Kaohsiung City 833169 (TW)
(72) Inventor: LIN, Chiu-Lang, Kaohsiung City 83067 (TW)
(74) Representative: V.O.

(56) References cited:
- EP-A1- 3 923 317
- WO-A1-2020/162417
- CN-U- 211 982 421

## Description

The disclosure relates to an electronic device, and more particularly to an electronic device that adopts a heat dissipation structure for dissipating heat from a heat-generating structure.

A liquid metal is a metal or a metal alloy that is in a liquid state at room temperature due to its low melting point or that is in a liquid state when heated to its melting point. Some examples of liquid metal include gallium indium tin alloy, indium bismuth tin alloy, and indium bismuth zinc alloy. Liquid metals have high stability and exceptional thermal and electrical conductivity. Moreover, the specific heat capacity and thermal conductivity of the liquid metals are much higher than those of the traditional silicone conductive pastes, so that they are now used as a thermal conductive agent between a heat source and heat-dissipating fins.

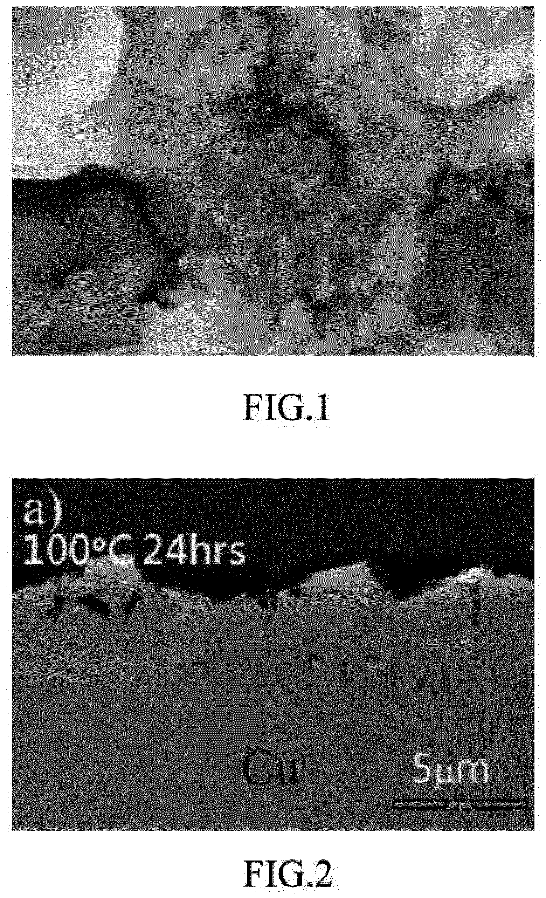

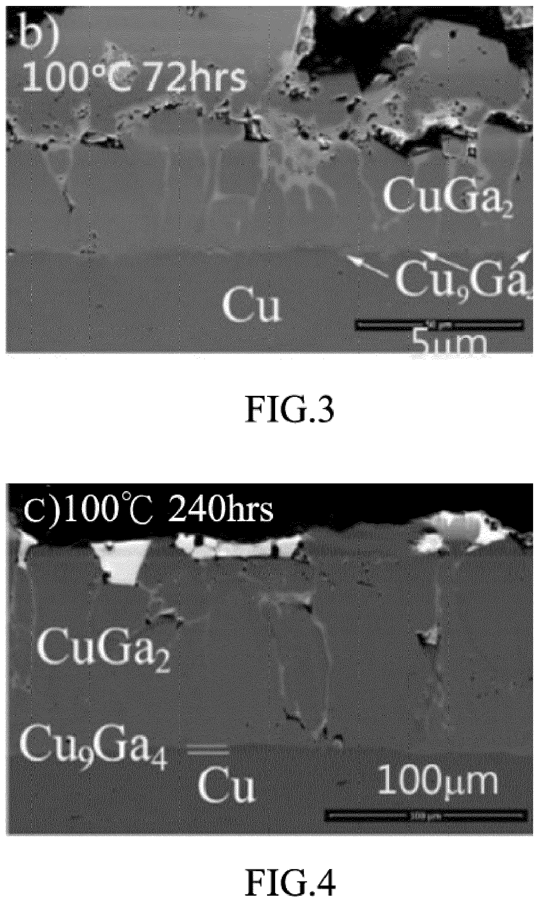

Aluminum or copper is often used as the main material for heat-dissipating fins. However, aluminum is easily corroded by gallium in the liquid metal, resulting in the damage of the heat-dissipating fins and losing the thermal conductivity of the liquid metal. On the other hand, compared to aluminum, copper has a much stable electron configuration due to the 10 electrons in its 3d orbital, and thus, copper does not corrode as easily as aluminum when in contact with gallium. Referring to FIG. 1, in actual practice, after a period of time and under high temperature, copper can still react with gallium to form a needle-like intermetallic compound CuGa, which is also known as liquid metal dry-out. This kind of intermetallic compound will continue to accumulate and thicken under long term use, as shown in FIGS. 2 to 4, and finally cause the liquid metal to lose its thermal and electrical conductivity. Further, if the liquid metal comes into contact with an electronic component or substrate, it is also easy to cause short circuit damage.

CN211982421U discloses a heat dissipation device including a heat sink, and a liquid metal layer arranged between the heat source and the heat sink, and the heat sink includes a sheet body facing the heat source, and an anti-corrosion metal layer plated on the sheet body. The liquid metal layer is attached to the anti-corrosion metal layer of the heat sink. WO2020162417 discloses a structure in which a metal having fluidity is utilized as a heat conductive material. In this structure, a heat conductive material is prevented from invading an unintended region even when a positional change of a semiconductor device occurs or a vibration occurs.

Therefore, an object of the present disclosure is to provide an electronic device that adopts a heat dissipation structure and that can alleviate at least one of the drawbacks of the prior art.

According to the present disclosure, there is provided an electronic device that includes a heat-generating structure and a heat dissipation structure. The heat-generating structure includes a substrate, an electronic component disposed on the substrate, and at least one electronic element disposed on the substrate and spaced apart from the electronic component. The heat dissipation structure includes a heat dissipation unit, a liquid metal layer, a blocking member, a fixing adhesive, an insulation layer, and a cushioning adhesive. The heat dissipation unit includes a heat dissipation body and an anti-corrosion layer formed on the heat dissipation body. The liquid metal layer is disposed between the electronic component and the heat dissipation body, and abuts against the anti-corrosion layer. The blocking member is disposed between the substrate and the anti-corrosion layer, is connected to the substrate, and surrounds the liquid metal layer and the electronic component. The fixing adhesive is disposed on the substrate, and is located between the electronic component and the blocking member. The insulation layer is disposed between the substrate and the anti-corrosion layer. The cushioning adhesive is disposed between the blocking member and the anti-corrosion layer. An insulation glue is disposed between said insulation layer and said substrate and encapsulating said at least one electronic element, wherein said insulation layer extends from said blocking member to said fixing adhesive and covers said insulation glue, and said cushioning adhesive is clamped between said insulation layer and said anti-corrosion layer.

Other features and advantages of the disclosure will become apparent in the following detailed description of the embodiments with reference to the accompanying drawings, of which:
FIG. 1 is a scanning electron microscope (SEM) image of a crystalline phase of a needle-like copper-gallium compound;
FIGS. 2 to 4 illustrate an accumulation process of the copper-gallium compound;
FIG. 5 is a sectional view of a first embodiment of an electronic device according to the present disclosure;
FIG. 6 is a fragmentary top view of the first embodiment;
FIG. 7 is a view similar to FIG. 5, but illustrating how the first embodiment can prevent a liquid metal layer from contacting electronic elements or a substrate;
FIG. 8 is a fragmentary top view of a second embodiment of the electronic device according to the present disclosure; and
FIG. 9 is a sectional view of a third embodiment of the electronic device according to the present disclosure.

Before the disclosure is described in greater detail, it should be noted that where considered appropriate, reference numerals or terminal portions of reference numerals have been repeated among the figures to indicate corresponding or analogous elements, which may optionally have similar characteristics.

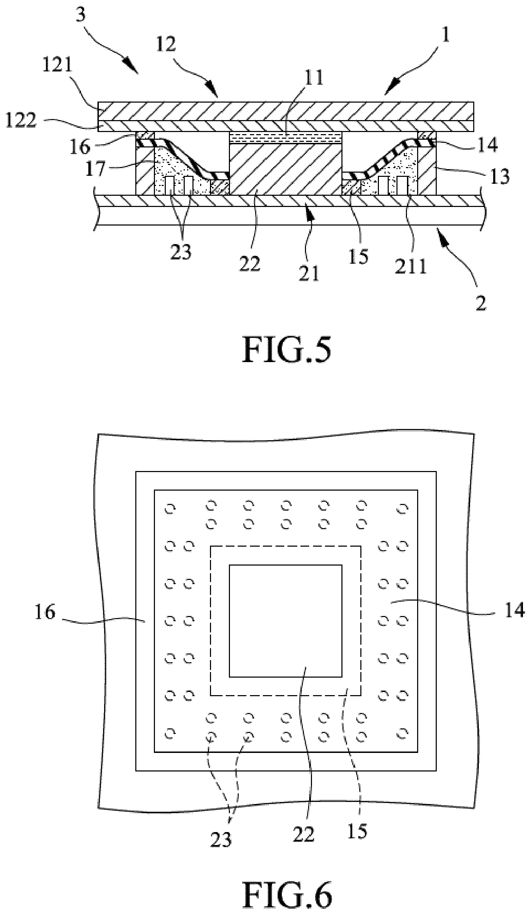

Referring to FIGS. 5 and 6, a first embodiment of an electronic device 3 according to the present disclosure includes a heat-generating structure 2, and a heat dissipation structure 1 for dissipating heat from the heat-generating structure 2.

The heat-generating structure 2 includes a substrate 21, an electronic component 22 disposed on the substrate 21, and a plurality of electronic elements 23 disposed on the substrate 1 and spaced apart from the electronic component 22. The heat-generating structure 2 may be, for example, but not limited to, a central processing unit (CPU) or a graphics processing unit (GPU). The substrate 21 includes a printed circuit layer 211 located on top thereof, but is not limited thereto. The electronic elements 23 may be capacitors or other components.

The heat dissipation structure 1 includes a liquid metal layer 11, a heat dissipation unit 12, a blocking member 13, a fixing adhesive 15, an insulation layer 14, and a cushioning adhesive 16.

The heat dissipation unit 12 includes a heat dissipation body 121 parallel to the substrate 21, and an anti-corrosion layer 122 formed on the heat dissipation body 121. The liquid metal layer 11 is disposed between the electronic component 22 and the heat dissipation body 121, and abuts against the anti-corrosion layer 122. In this embodiment, the liquid metal layer 11 is coated on the electronic component 22, but is not limited thereto. The liquid metal layer 11 may be coated on the anti-corrosion layer 122 or on both of the electronic component 22 and the anti-corrosion layer 122, as long as the liquid metal layer 11 is disposed between the heat-generating structure 2 and the heat dissipation unit 12. The heat dissipation body 121 may be made of, but not limited to, copper, aluminum, and alloys thereof. The anti-corrosion layer 122 may be made of, for example, one of a metallic material including nickel plated metal, gold, electroless nickel electroless palladium immersion gold (ENEPIG), silver, and stainless steel, or one of a non-metallic material including graphite and ceramic.

The blocking member 13 is disposed between the substrate 21 and the anti-corrosion layer 122, is connected to the substrate 21, and surrounds and is spaced apart from the electronic component 22. The blocking member 13 may be connected to the substrate 21 by adhesion, latching, or integrally forming with the substrate 21. The electronic elements 23 are disposed between the electronic component 22 and the blocking member 13. The fixing adhesive 15 is disposed on the substrate 21, and is located between the electronic component 22 and the blocking member 13. The fixing adhesive 15 may be, for example, a single-sided adhesive, a double-sided adhesive, or other polymeric materials.

The insulation layer 14 is disposed between the substrate 21 and the anti-corrosion layer 122. In this embodiment, the insulation layer 14 extends from the blocking member 13 to the fixing adhesive 15, and covers the electronic elements 23. Specifically, the insulation layer 14 has an outer peripheral edge clamped between the blocking member 13 and the cushioning adhesive 16, and an inner peripheral edge connected to an outer surface of the electronic component 22 and abutting against a top side of the fixing adhesive 15. The insulation layer 14 is a polymeric material, and may be provided with a single-sided adhesive at a side facing the substrate 21.

The cushioning adhesive 16 is disposed between the blocking member 13 and the anti-corrosion layer 122. Specifically, the cushioning adhesive 16 of this embodiment is clamped between the insulation layer 14 and the anti-corrosion layer 122.

It should be noted herein that, in this embodiment, an insulation glue 17 is disposed between the insulation layer 14 and the substrate 21 to enhance the insulating effect. The insulation glue 17 encapsulates the electronic elements 23, and can be adhered to the insulation layer 14 or the substrate 21.

The anti-corrosion layer 122 is disposed between the heat dissipation body 121 and the liquid metal layer 11 to prevent the liquid metal layer 11 from directly contacting the heat dissipation body 121 during heat dissipation, thereby preventing the heat dissipation body 121 from being corroded by the liquid metal layer 11 or forming an intermetallic compound therewith. Thus, damage of the heat dissipation body 121 can be avoided, and the heat dissipation stability of the liquid metal layer 11 can be ensured.

In this embodiment, the fixing adhesive 15 has a square shape, and surrounds the electronic component 22, as shown in FIG. 6. Specifically, the fixing adhesive 15 is located between the electronic elements 23 and the electronic component 22, and has an upper surface adhered to the insulation layer 14 and a lower surface adhered to the substrate 21. The insulation layer 14 is of insulating material, has the inner and outer peripheral edges respectively adhered to the fixing adhesive 15 and the blocking member 13, and is located above the electronic elements 23 in order to cover the same. In some other embodiments, the outer peripheral edge of the insulation layer 14 may be directly disposed on the substrate 21 instead of being connected to the blocking member 13.

The cushioning adhesive 16 is made of a polymeric material. In this embodiment, the cushioning adhesive 16 is a foam tape, and may be located above the blocking member 13 or between an inner side of the blocking member 13 and the electronic component 22. The cushioning adhesive 16 has a lower surface adhered to the outer peripheral edge of the insulation layer 14 and an upper surface adhered to the anti-corrosion layer 122. In some other embodiments, the cushioning adhesive 16 may not be adhered to the anti-corrosion layer 122, but is directly pressed on the anti-corrosion layer 122.

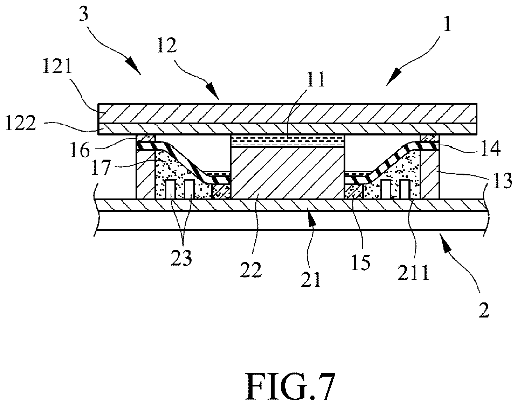

Referring to FIG. 7, in combination with FIGS. 5 and 6, due to the fluidity of the liquid metal layer 11, the liquid metal layer 11 may flow onto the substrate 21. Through the blocking of the fixing adhesive 15 and the insulation layer 14, the liquid metal layer 11 can be prevented from contacting the electronic elements 23 and the substrate 21, thereby avoiding short circuiting or corroding of other components. The blocking member 13 can block and prevent the liquid metal layer 11 from overflowing to a motherboard which can cause short circuit and corrosion problems. Further, a user may adhere the fixing adhesive 15, the insulation layer 14, the blocking member 13, and the cushioning adhesive 16 on the heat-generating structure 2 by himself or herself according to the different configurations of the heat-generating structure 2, so that they are suitable to be used in a heat-generating structure 2 that is commercially available in the market. Thus, the versatility of this disclosure can be improved.

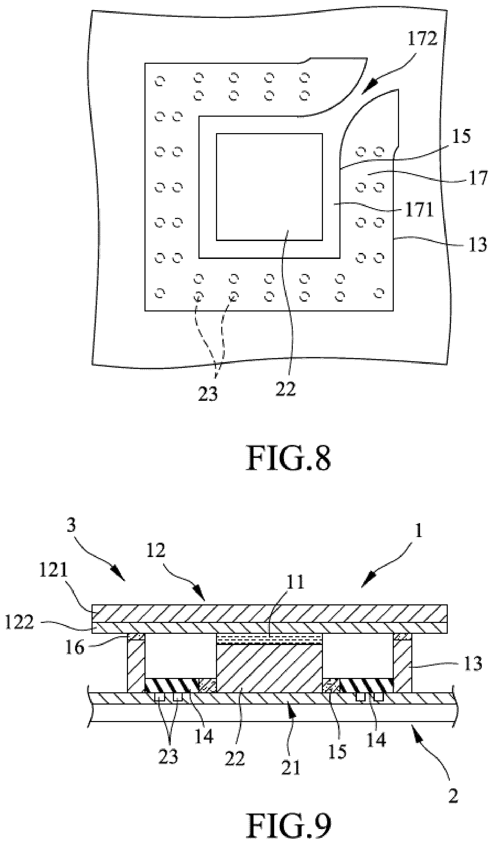

Referring to FIG. 8, a second embodiment of the electronic device 3 of this disclosure is substantially the same as the first embodiment, except that, in the second embodiment, the fixing adhesive 15 is spaced apart from the electronic component 22 to form a space 171 therebetween, and has an opening 172 for communicating the space 171 with an external environment. That is, the fixing adhesive 15 has a square shape with a missing corner and surrounds the electronic component 22. When an automated production of the electronic device 3 is performed and the heat dissipation unit 12 is quickly covered on the liquid metal layer 11, air that enters the space 171 along with the heat dissipation unit 12 can be dissipated to the external environment through the opening 172, thereby preventing short circuiting and/or corroding of the electronic elements 23 after the heat dissipation unit 12 is adhered to the insulation glue 17. Without the presence of the opening 172, after the heat dissipation unit 12 is adhered to the insulation glue 17, air in the space 171 has nowhere to escape, causing liquid metal to spatter onto the electronic elements 23, thereby short circuiting and/or corroding the electronic elements 23. To be noted is that, the insulation glue 17 is an insulating glue that can be dispensed using an automatic dispenser.

Referring to FIG. 9, a third embodiment of the electronic device 3 according to the present disclosure is substantially the same as the first embodiment, except that, in the third embodiment, the electronic elements 23 are embedded in the substrate 21 and are located below the insulation layer 14 and the fixing adhesive 15. Further, the outer peripheral edge of the insulation layer 14 abuts against the blocking member 13, and the inner peripheral edge thereof abuts against the fixing adhesive 15. Moreover, the blocking member 13 surrounds the liquid metal layer 11, and the cushioning adhesive 16 is disposed and clamped between the blocking member 13 and the anti-corrosion layer 122.

In summary, by forming an anti-corrosion layer 122 on the heat dissipation body 121 of the heat dissipation unit 12, the anti-corrosion layer 122 can prevent direct contact between the liquid metal layer 11 and the heat dissipation body 121, so that reaction and corrosion between the two can be avoided, thereby improving stability and durability of the heat dissipation structure 1 of this disclosure. Moreover, the insulation layer 14 and the fixing adhesive 15 can cover the electronic elements 23 to prevent them from short circuiting due to contact with the liquid metal layer 11. In addition, the opening 172 can dissipate air in the space 171 to the external environment, thereby preventing the air from affecting the liquid metal layer 11 and spattering of liquid metal onto the electronic elements 23, which can cause short circuiting and/or corroding thereof. Therefore, this disclosure can adapt to rapid automated manufacturing processes.

## Claims

1. An electronic device (3), **characterized by**:
a heat-generating structure (2) including a substrate (21), an electronic component (22) disposed on said substrate (21), and at least one electronic element (23) disposed on said substrate (21) and spaced apart from said electronic component (22);
a heat dissipation structure (1) including:
a heat dissipation unit (12) that includes a heat dissipation body (121) and an anti-corrosion layer (122) formed on said heat dissipation body (121),
a liquid metal layer (11) disposed between said electronic component (22) and said heat dissipation body (121) and abutting against said anti-corrosion layer (122),
a blocking member (13) that is disposed between said substrate (21) and said anti-corrosion layer (122), that is connected to said substrate (21), and that surrounds said liquid metal layer (11) and said electronic component (22),
a fixing adhesive (15) that is disposed on said substrate (21) and that is located between said electronic component (22) and said blocking member (13),
an insulation layer (14) disposed between said substrate (21) and said anti-corrosion layer (122); **characterized by**
a cushioning adhesive (16) disposed between said blocking member (13) and said anti-corrosion layer (122); and
an insulation glue (17) disposed between said insulation layer (14) and said substrate (21) and encapsulating said at least one electronic element (23);
wherein said insulation layer (14) extends from said blocking member (13) to said fixing adhesive (15) and covers said insulation glue (17), and said cushioning adhesive (16) is clamped between said insulation layer (14) and said anti-corrosion layer (122) .

2. The electronic device (3) as claimed in claim 1, **characterized in that** said anti-corrosion layer (122) is made of one of nickel plated metal, gold, electroless nickel electroless palladium immersion gold, silver, stainless steel, graphite, and ceramic.

3. The electronic device (3) as claimed in claims 1 or 2, **characterized in that** said at least one electronic element (23) is disposed between said electronic component (22) and said blocking member (13) .

4. The electronic device (3) as claimed in any one of claims 1 to 3, **characterized in that** an outer peripheral edge of said insulation layer (14) is clamped between said blocking member (13) and said cushioning adhesive (16).

5. The electronic device (3) as claimed in any one of claims 1 to 4, **characterized in that** said fixing adhesive (15) is spaced apart from said electronic component (22) to form a space (171) therebetween and has an opening (172) for communicating said space (171) with an external environment.

6. The electronic device (3) as claimed in any one of claims 1 to 5, **characterized in that** said fixing adhesive (15) is one of a single-sided adhesive, a double-sided adhesive, and a polymeric material.

7. The electronic device (3) as claimed in any one of claims 1 to 6, **characterized in that** said cushioning adhesive (16) is made of a polymeric material.

8. The electronic device (3) as claimed in claim 7, **characterized in that** said cushioning adhesive (16) is a foam tape.

9. The electronic device (3) as claimed in any one of claims 1 to 8, **characterized in that** said insulation layer (14) is a polymeric material.

10. The electronic device (3) as claimed in any one of claims 1 to 9, **characterized in that** said insulation layer (14) is provided with a single-sided adhesive at a side facing said substrate (21).

## Patentansprüche

1. Elektronische Einrichtung (3), **gekennzeichnet durch**:
eine wärmeerzeugende Struktur (2), die ein Substrat (21), eine auf dem Substrat (21) angeordnete elektronische Komponente (22) und mindestens ein elektronisches Element (23) einschließt, das auf dem Substrat (21) angeordnet und von der elektronischen Komponente (22) beabstandet ist;
eine wärmeableitende Struktur (1), einschließend:
eine wärmeableitende Einheit (12), die einen wärmeableitenden Körper (121) und eine auf dem wärmeableitenden Körper (121) ausgebildete Antikorrosionsschicht (122) einschließt,
eine Flüssigmetallschicht (11), die zwischen der elektronischen Komponente (22) und dem wärmeableitenden Körper (121) angeordnet ist und sich gegen die Korrosionsschutzschicht (122) abstützt,
ein Blockierelement (13), das zwischen dem Substrat (21) und der Antikorrosionsschicht (122) angeordnet ist, das mit dem Substrat (21) verbunden ist und das die Flüssigmetallschicht (11) und die elektronische Komponente (22) umgibt,
einen Fixierklebstoff (15), der auf dem Substrat (21) angeordnet ist und der sich zwischen der elektronischen Komponente (22) und dem Blockierelement (13) befindet,
eine Isolierschicht (14), die zwischen dem Substrat (21) und der Antikorrosionsschicht (122) angeordnet ist; **gekennzeichnet durch**
einen Dämpfungsklebstoff (16), der zwischen dem Blockierelement (13) und der Antikorrosionsschicht (122) angeordnet ist; und
einen Isolierklebstoff (17), der zwischen der Isolierschicht (14) und dem Substrat (21) angeordnet ist und das mindestens eine elektronische Element (23) einkapselt;
wobei sich die Isolierschicht (14) von dem Blockierelement (13) zu dem Fixierklebstoff (15) erstreckt und den Isolierklebstoff (17) abdeckt, und der Dämpfungsklebstoff (16) zwischen der Isolierschicht (14) und der Antikorrosionsschicht (122) eingeklemmt ist.

2. Elektronische Einrichtung (3) nach Anspruch 1, **dadurch gekennzeichnet, dass** die Antikorrosionsschicht (122) aus einem vernickelten Metall, Gold, stromlosem Nickel, stromlosem Palladium-Tauchgold, Silber, rostfreiem Stahl, Graphit oder Keramik hergestellt ist.

3. Elektronische Einrichtung (3) nach Anspruch 1 oder 2, **dadurch gekennzeichnet, dass** das mindestens eine elektronische Element (23) zwischen der elektronischen Komponente (22) und dem Blockierelement (13) angeordnet ist.

4. Elektronische Einrichtung (3) nach einem der Ansprüche 1 bis 3, **dadurch gekennzeichnet, dass** eine äußere periphere Kante der Isolierschicht (14) zwischen dem Blockierelement (13) und dem Dämpfungsklebstoff (16) eingeklemmt ist.

5. Elektronische Einrichtung (3) nach einem der Ansprüche 1 bis 4, **dadurch gekennzeichnet, dass** der Fixierklebstoff (15) von der elektronischen Komponente (22) beabstandet ist, um einen Raum (171) dazwischen zu bilden, und eine Öffnung (172) aufweist, um den Raum (171) mit einer äußeren Umgebung zu kommunizieren.

6. Elektronische Einrichtung (3) nach einem der Ansprüche 1 bis 5, **dadurch gekennzeichnet, dass** der Fixierklebstoff (15) einer aus einem einseitigen Klebstoff, einem doppelseitigen Klebstoff und einem polymeren Material ist.

7. Elektronische Einrichtung (3) nach einem der Ansprüche 1 bis 6, **dadurch gekennzeichnet, dass** der Dämpfungsklebstoff (16) aus einem polymeren Material besteht.

8. Elektronische Einrichtung (3) nach Anspruch 7, **dadurch gekennzeichnet, dass** der Dämpfungsklebstoff (16) ein Schaumstoffband ist.

9. Elektronische Einrichtung (3) nach einem der Ansprüche 1 bis 8, **dadurch gekennzeichnet, dass** die Isolierschicht (14) aus einem polymeren Material besteht.

10. Elektronische Einrichtung (3) nach einem der Ansprüche 1 bis 9, **dadurch gekennzeichnet, dass** die Isolierschicht (14) an einer dem Substrat (21) zugewandten Seite mit einem einseitigen Klebstoff bereitgestellt ist.

## Revendications

1. Dispositif électronique (3) **caractérisé par** :
une structure génératrice de chaleur (2) comprenant un substrat (21), un composant électronique (22) disposé sur ledit substrat (21), et au moins un élément électronique (23) disposé sur ledit substrat (21) et espacé dudit composant électronique (22) ;
une structure de dissipation de chaleur (1) comprenant :
une unité de dissipation de chaleur (12) qui comprend un corps de dissipation de chaleur (121) et une couche anticorrosion (122) formée sur ledit corps de dissipation de chaleur (121),
une couche de métal liquide (11) disposée entre ledit composant électronique (22) et ledit corps de dissipation de chaleur (121) et venant en butée contre ladite couche anticorrosion (122),
un élément de blocage (13) qui est disposé entre ledit substrat (21) et ladite couche anticorrosion (122), qui est connecté audit substrat (21), et qui entoure ladite couche de métal liquide (11) et ledit composant électronique (22),
un adhésif de fixation (15) qui est disposé sur ledit substrat (21) et qui est situé entre ledit composant électronique (22) et ledit élément de blocage (13),
une couche d'isolation (14) disposée entre ledit substrat (21) et ladite couche anticorrosion (122) ;
**caractérisé par**
un adhésif amortisseur (16) disposé entre ledit élément de blocage (13) et ladite couche anticorrosion (122) ; et
une colle d'isolation (17) disposée entre ladite couche d'isolation (14) et ledit substrat (21) et encapsulant ledit au moins un élément électronique (23) ;
dans lequel ladite couche d'isolation (14) s'étend dudit élément de blocage (13) audit adhésif de fixation (15) et couvre ladite colle d'isolation (17), et ledit adhésif d'amortissement (16) est serré entre ladite couche d'isolation (14) et ladite couche anticorrosion (122) .

2. Dispositif électronique (3) selon la revendication 1, **caractérisé en ce que** ladite couche anticorrosion (122) est fait d'un ou plusieurs parmi un métal plaqué de nickel, l'or, l'or avec immersion dans du palladium autocatalytique et du nickel autocatalytique, l'argent, un acier inoxydable, le graphite, et une céramique.

3. Dispositif électronique (3) selon la revendication 1 ou 2, **caractérisé en ce que** ledit au moins un élément électronique (23) est disposé entre ledit composant électronique (22) et ledit élément de blocage (13).

4. Dispositif électronique (3) selon l'une quelconque des revendications 1 à 3, **caractérisé en ce qu'**un bord périphérique extérieur de ladite couche d'isolation (14) est serré entre ledit élément de blocage (13) et ledit adhésif amortisseur (16).

5. Dispositif électronique (3) selon l'une quelconque des revendications 1 à 4, **caractérisé en ce que** ledit adhésif de fixation (15) est espacé dudit composant électronique (22) pour former un espace (171) entre eux et a une ouverture (172) pour faire communiquer ledit espace (171) avec un environnement externe.

6. Dispositif électronique (3) selon l'une quelconque des revendications 1 à 5, **caractérisé en ce que** ledit adhésif de fixation (15) est l'un parmi un adhésif simple face, un adhésif double face, et un matériau polymère.

7. Dispositif électronique (3) selon l'une quelconque des revendications 1 à 6, **caractérisé en ce que** ledit adhésif amortisseur (16) est fait d'un matériau polymère.

8. Dispositif électronique (3) selon la revendication 7, **caractérisé en ce que** ledit adhésif amortisseur (16) est une bande de mousse.

9. Dispositif électronique (3) selon l'une quelconque des revendications 1 à 8, **caractérisé en ce que** ladite couche d'isolation (14) est un matériau polymère.

10. Dispositif électronique (3) selon l'une quelconque des revendications 1 à 9, **caractérisé en ce que** ladite couche d'isolation (14) est dotée d'un adhésif simple face sur un côté faisant face audit substrat (21) .
